# EUROPEAN PATENT APPLICATION

(11) **EP 4 589 661 A1**
(43) Date of publication of application: **23.07.2025**
(21) Application number: 22962143.8
(22) Date of filing: 11.10.2022
(51) Int. Cl.: H01L 27/15, H01L 27/12, H01L 33/52, H01L 25/075

(54) **DISPLAY APPARATUS OF SEMICONDUCTOR LIGHT EMITTING DEVICE**

(71) Applicant: LG Electronics Inc., Yeongdeungpo-gu Seoul 07336 (KR); LG Display Co., Ltd., Seoul, 07336 (KR)
(72) Inventor: AN, Kitae, Seoul 06772 (KR); SHIM, Bongchu, Seoul 06772 (KR); JUN, Jinhyung, Seoul 06772 (KR); CHO, Hyunwoo, Seoul 06772 (KR)
(74) Representative: Vossius & Partner Patentanwälte Rechtsanwälte mbB
(86) International application number: PCT/KR2022/015295
(87) International publication number: WO 2024/080392

(57) **Abstract**

The embodiment relates to a display device of a semiconductor light emitting device.

A display device of a semiconductor light emitting device according to the embodiment may include a first display module substrate and a second display module substrate disposed adjacently, a plurality of semiconductor light emitting device assemblies disposed on the first, second display module substrates, first and second side wirings disposed on the sides of the first, second display module substrates respectively and electrically connected to the semiconductor light emitting device assemblies, and a porous adhesive resin layer disposed between the first display module substrate and the second display module substrate.

## Description

### [Technical Field]

The embodiment relates to a display device of semiconductor light emitting device.

### [Background art]

Large-area display devices include liquid crystal displays (LCDs), OLED displays, and micro-LED displays.

A micro-LED display is a display that uses micro-LEDs, semiconductor light emitting devices with a diameter or cross-sectional area of 100*µ*m or less, as display elements.

Since a micro-LED display uses micro-LEDs, semiconductor light emitting devices, as display elements, it has excellent performance in many characteristics such as contrast ratio, response speed, color reproducibility, viewing angle, brightness, resolution, lifespan, luminous efficiency, and luminance.

In particular, a micro-LED display has the advantage of being able to freely adjust the size or resolution by separating and combining the screen in a modular manner, and the advantage of being able to implement a flexible display.

However, since large micro-LED displays require millions or more micro-LEDs, there is a technical problem in quickly and accurately transferring micro-LEDs to the display panel.

Recently developed transfer technologies include the pick and place process, the laser lift-off method, and the self-assembly method. Among these, the self-assembly method is a method in which semiconductor light emitting devices find their assembly positions within a fluid, which is advantageous for implementing large-screen display devices.

Meanwhile, conventional display devices using semiconductor light emitting devices are manufactured by transferring semiconductor light emitting devices onto substrates such as TFT substrates or wiring boards, but there is a problem in that productivity is low due to the transfer defect rate of semiconductor light emitting devices, and in particular, the production yield of large-area display devices is extremely low.

To solve these problems, research and development are currently being conducted on 'multi-screen display devices' that implement large-screen display devices by tiling multiple semiconductor light emitting device display modules with relatively small sizes.

However, in the case of a multi-screen display device, a gap area may occur between the connected unit display devices due to the bezel area existing at the edge of each unit display device. The bezel area exists due to side electrodes (or side wiring) for electrical connection between the components disposed on the upper side of the substrate and the components disposed on the lower side of the substrate.

This gap area may cause a sense of disconnection and heterogeneity in the image by recognizing the gap or boundary line between the modules as a 'visually recognizable' seam when displaying one image on the entire area of the multi-screen display device, thereby reducing the immersion of the image.

Meanwhile, there are studies to improve the seam between modules in a multi-screen display device in which multiple display modules are tiled in the prior art.

For example, prior art 1 (Korean publication number: 10-2019-0046684) has a structure in which a light absorbing layer is disposed on each mold side, but there is still a gap in the light absorbing layer between adjacent display modules, so there is a limitation in the existence of a seam.

In addition, prior art 2 (Korean publication number: 10-2020-0014057) has a structure in which a PR film is disposed on the seam area between modules, but if there is still an empty space between the modules, a visibility problem due to the seam area may occur if the PR film is poorly attached. In addition, since the seam area is an empty space, it is difficult to attach a PR film thereon, and if PR is attached to a pixel, pixel defects may occur.

Meanwhile, in prior technologies, multiple display modules are tiled on a given chassis or cabinet, but no separate physical connection is attempted between the side areas of adjacent display modules, so there is a problem of weak mechanical reliability.

Meanwhile, in the display device of the internal technology, even if the gap between the tiled display modules is physically and mechanically reduced or eliminated, there is a problem that the boundary line is optically and visually recognized as a seam.

Accordingly, it is necessary to prevent the gap between the display modules from being recognized as a seam optically, rather than just physically eliminating it.

In addition, in the multi-screen display device of the internal technology, the height difference between the upper surfaces of the tiled display modules occurs, resulting in a surface step between the display modules.

Accordingly, even if the gap between the display modules is filled, if a surface step occurs between the display modules, there is a problem that it is optically recognized as a serious seam.

### [Disclosure]

### [Technical Problem]

One of the technical objects of the embodiment is to solve the problem of weak mechanical reliability between the side areas of adjacent display modules when multiple display modules are tiled.

Another technical problem of the embodiment is to the gap between the display modules not recognized as a seam optically and visually, rather than physically eliminating the gap.

Another technical problem of the embodiment is to solve the problem that even if the gap between the display modules is filled, if a surface step occurs between the display modules, the gap is recognized as a serious seam optically.

The technical problem of the embodiment is not limited to what is described in this item, but includes what can be understood throughout the entire specification.

### [Technical Solution]

A display device of a semiconductor light emitting device according to an embodiment may include a first display module substrate and a second display module substrate that are disposed adjacently, a plurality of semiconductor light emitting device assemblies disposed on the first, second display module substrates, first and second side wirings that are disposed on the sides of the first, second display module substrates and are electrically connected to the semiconductor light emitting device assemblies, and a porous adhesive resin layer disposed between the first display module substrate and the second display module substrate.

The porous adhesive resin layer includes a first porous adhesive resin layer disposed on the first side wiring of the first display module substrate and a second porous adhesive resin layer disposed on the second side wiring of the second display module substrate, and the first and second porous adhesive resin layers may be combined to form a single body.

In the embodiment, a surface step may exist between the upper surface of the first display module substrate and the upper surface of the second display module substrate.

In addition, the embodiment may further include a planarizing film disposed on the first and second module substrates.

In addition, the embodiment may further include an optical adhesive layer and a cover film disposed on the first and second module substrates.

In addition, the display device of the semiconductor light emitting device according to the embodiment may include a first display module substrate and a second display module substrate disposed adjacently, a plurality of semiconductor light emitting device assemblies disposed on the first, second display module substrates, first and second side wirings disposed on the sides of the first, second display module substrates and electrically connected to the semiconductor light emitting device assemblies, and a viscoelastic resin layer disposed between the first display module substrate and the second display module substrate.

The viscoelastic resin layer includes a first viscoelastic resin layer disposed on the first side wiring of the first display module substrate and a second viscoelastic resin layer disposed on the second side wiring of the second display module substrate, and the first and second viscoelastic resin layers may be combined to form a single body.

In addition, the embodiment may have a surface step between the upper surface of the first display module substrate and the upper surface of the second display module substrate.

In addition, the embodiment may further include a flattening film disposed on the first and second module substrates.

In addition, the embodiment may further include an optical adhesive layer and a cover film disposed on the first and second module substrates.

### [Advantageous Effects]

The display device of the semiconductor light emitting device according to the embodiment has a technical effect of solving the problem of weak mechanical reliability between side areas of adjacent display modules when a plurality of display modules are tiled.

For example, according to the embodiment, there is a technical effect that a perfect seamless implementation is possible by directly bonding between modules using a porous adhesive resin layer (790) as a medium, so that there is no gap between the modules. In addition, according to the embodiment, there is a technical effect that a porous adhesive resin layer (790) is directly bonded between modules, so that there is no need to separately fix the modules, and there is a technical effect that is structurally reliable.

In addition, the display device of the semiconductor light emitting device according to the embodiment has a technical effect that does not physically eliminate the gap between the display modules, but optically and visually prevents it from being recognized as a seam.

For example, the porous adhesive resin layer (790) of the embodiment has a special technical effect that functions as a light-absorbing layer as a soft porous material, and reduces reflection by external light into the porous space and traps it, thereby reducing seam recognition.

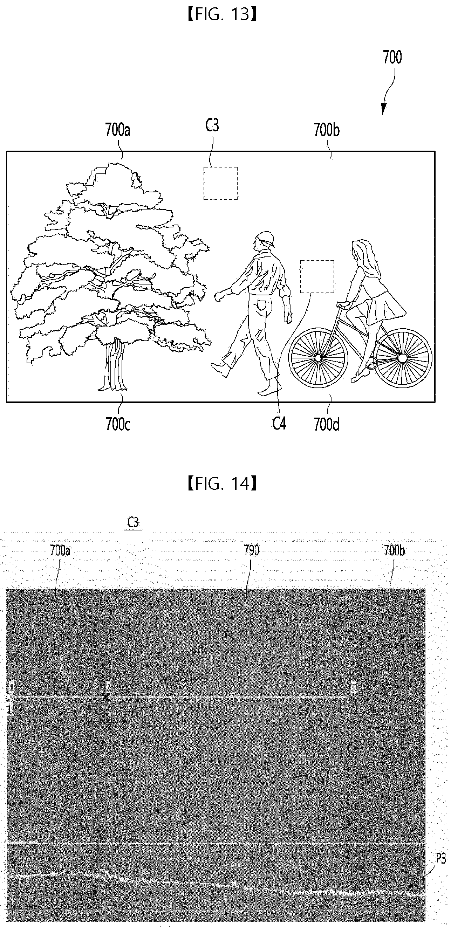

Specifically, FIG. 14 is a surface photograph of the third boundary area (C1) of the first display module (700a) and the second display module (700b), and since a porous adhesive resin layer (790) is placed between the adjacent first display module (700a) and the second display module (700b), there is a special technical effect that the boundary line is not recognized as a seam optically or visually.

In addition, the display device of the semiconductor light emitting device according to the embodiment has a technical effect that can solve the problem that the gap between the display modules is filled, but the surface step between the display modules is recognized as a serious seam optically.

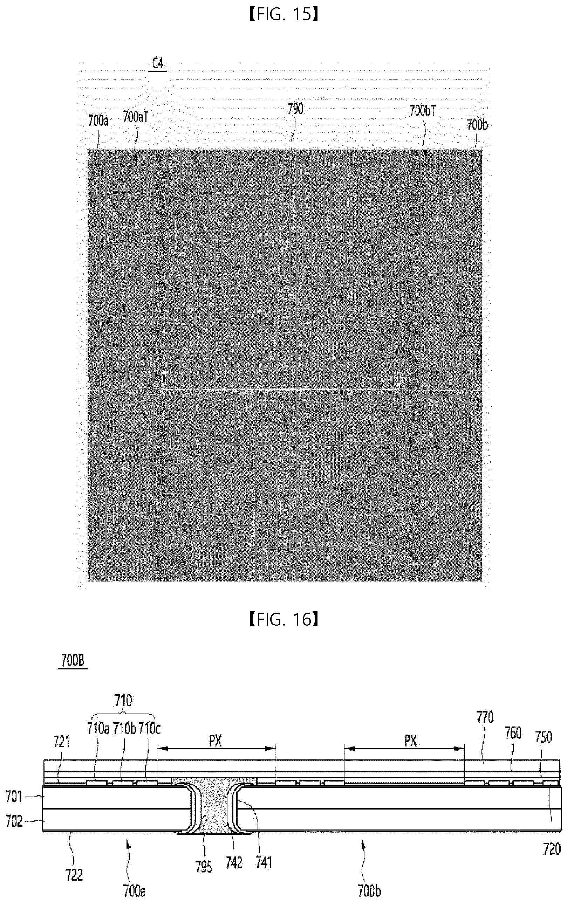

For example, FIG. 15 is a surface photograph of the fourth boundary area (C4) of the first display module (700a) and the second display module (700b), and even if there is a height step between the upper surface (700aT) of the tiled first display module and the upper surface (700bT) of the second display module, the porous adhesive resin layer (790) is disposed to function as a seam light-absorbing layer, so that the reflection by external light is diffusely reflected and trapped into the porous space, so that it is not recognized as a seam optically and visually.

In addition, the display device (700B) according to the second embodiment can place a viscoelastic resin layer (795) on the first display module (700a) and the second display module (700b), and this viscoelastic resin layer (795) can reduce reflection due to external light, thereby reducing the perception of depth.

The technical effects of the embodiment are not limited to those described in this item, but include those that can be understood throughout the entire specification.

### [Description of Drawings]

FIG. 1 is an example diagram of a living room of a house in which a display device according to the embodiment is placed.
FIG. 2 is a block diagram schematically showing a display device according to the embodiment.
FIG. 3 is a circuit diagram showing an example of a pixel of FIG. 2.
FIG. 4 is an enlarged view of the first panel area in the display device of FIG. 1.
FIG. 5 is a cross-sectional view along the line B1-B2 of the A2 area of FIG. 4.
FIG. 6 is an exemplary diagram of a light emitting device according to an embodiment being assembled on a substrate by a self-assembly method.
FIG. 7 is an exemplary diagram of a multi-screen display device including a plurality of display panels according to an internal technology.
FIG. 8 is an exemplary diagram of a surface photograph of a first area of a display device including a plurality of display panels shown in FIG. 7.
FIG. 9 is an exemplary diagram of a surface photograph of a second area (C2) of a display device (700) including a plurality of display panels shown in FIG. 7.
FIG. 10 is a 3D profile data for each component of FIG. 9.
FIG. 11 is a side view of a boundary area between display modules of a display device (700) according to the first embodiment.
FIG. 12 is an exemplary diagram of a manufacturing method of a display device (700) according to the first embodiment.
FIG. 13 is an exemplary diagram of a multi-screen display device (700) including a plurality of display panels according to an embodiment.
FIG. 14 is an example of a surface photograph of the third area (C3) of the display device (700) illustrated in FIG. 13.
FIG. 15 is an example of a surface photograph of the fourth area (C4) of the display device (700) illustrated in FIG. 15.
FIG. 16 is a side view of a boundary area between display modules of the display device (700B) according to the second embodiment.
FIG. 17 is an example of a manufacturing method of the display device (700B) according to the second embodiment.

### [Mode for Invention]

Hereinafter, the embodiments disclosed in this specification will be described in detail with reference to the attached drawings. The suffixes 'module' and 'part' used for components in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is referred to as existing 'on' another element, it includes that it may be directly on the other element or that other intermediate elements may exist between them.

The display device described in this specification may include a digital TV, a mobile phone, a smart phone, a laptop computer, a digital broadcasting terminal, a personal digital assistant (PDA), a portable multimedia player (PMP), a navigation, a slate PC, a tablet PC, an Ultra-Book, a desktop computer, and the like. However, the conFIGuration according to the embodiments described in this specification may also be applied to a device capable of displaying, even if it is a new product type developed in the future.

Hereinafter, a light emitting device according to an embodiment and a display device including the same will be described.

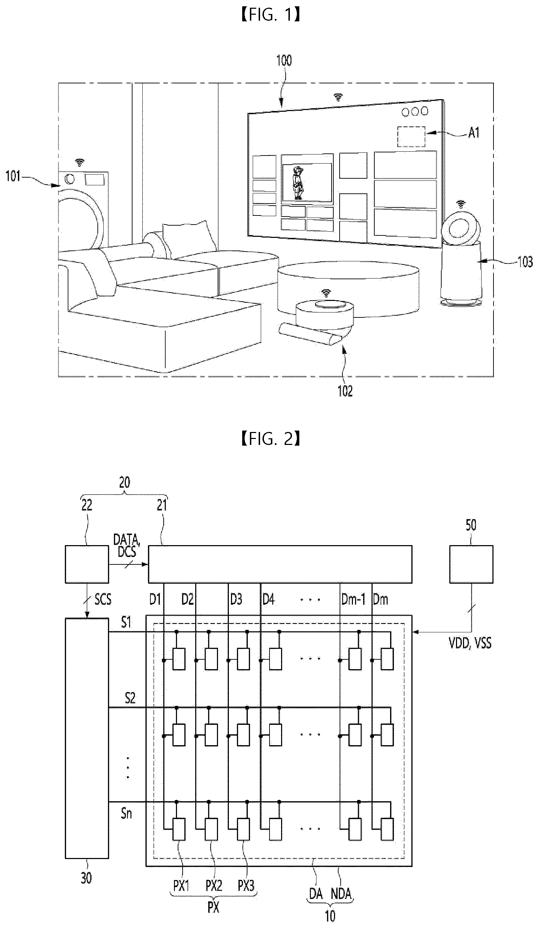

FIG. 1 illustrates a living room of a house in which a display device (100) according to an embodiment is placed.

The display device (100) according to the embodiment can display the status of various electronic products such as a washing machine (101), a robot vacuum cleaner (102), and an air purifier (103), communicate with each electronic product based on IOT, and control each electronic product based on the user's setting data.

The display device (100) according to the embodiment can include a flexible display manufactured on a thin and flexible substrate. The flexible display can be bent or rolled like paper while maintaining the characteristics of a conventional flat panel display.

In the flexible display, visual information can be implemented by independently controlling the light emission of unit pixels disposed in a matrix form. A unit pixel means a minimum unit for implementing one color. The unit pixel of the flexible display can be implemented by a light emitting device. In the embodiment, the light emitting device may be a Micro-LED or Nano-LED, but is not limited thereto.

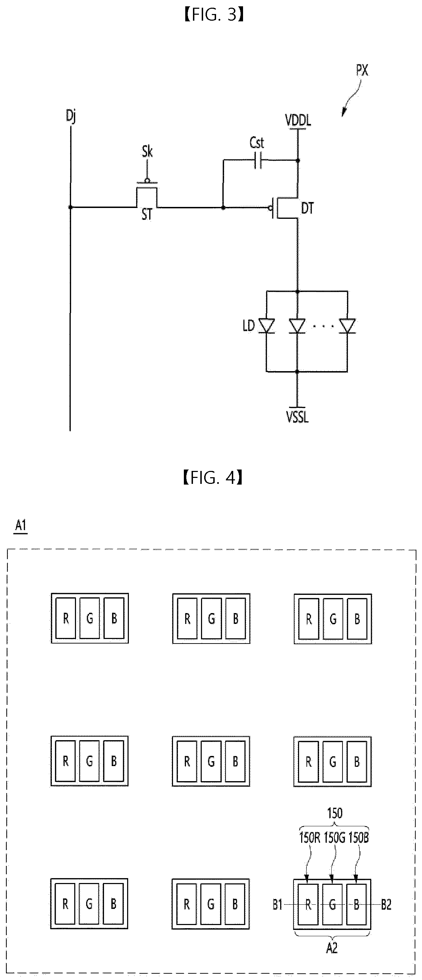

FIG. 2 is a block diagram schematically showing a display device according to an embodiment, and FIG. 3 is a circuit diagram showing an example of a pixel of FIG. 2.

Referring to FIGS. 2 and 3, the display device according to the embodiment may include a display panel (10), a driving circuit (20), a scan driving unit (30), and a power supply circuit (50).

The display device (100) of the embodiment may drive the light emitting device in an active matrix (AM) method or a passive matrix (PM) method.

The driving circuit (20) may include a data driving unit (21) and a timing control unit (22).

The display panel (10) may be divided into a display area (DA) and a non-display area (NDA) disposed around the display area (DA). The display area (DA) is an area where pixels (PX) are formed to display an image. The display panel (10) may include data lines (D1 to Dm, m is an integer greater than or equal to 2), scan lines (S1 to Sn, n is an integer greater than or equal to 2) intersecting the data lines (D1 to Dm), a high-potential voltage line to which a high-potential voltage is supplied, a low-potential voltage line to which a low-potential voltage is supplied, and pixels (PX) connected to the data lines (D1 to Dm) and the scan lines (S1 to Sn).

Each of the pixels (PX) may include a first sub-pixel (PX1), a second sub-pixel (PX2), and a third sub-pixel (PX3). The first sub-pixel (PX1) may emit a first color light of a first wavelength, the second sub-pixel (PX2) may emit a second color light of a second wavelength, and the third sub-pixel (PX3) may emit a third color light of a third wavelength. The first color light may be red light, the second color light may be green light, and the third color light may be blue light, but the present invention is not limited thereto. In addition, although FIG. 2 exemplifies that each of the pixels (PX) includes three sub-pixels, the present invention is not limited thereto. That is, each of the pixels (PX) may include four or more sub-pixels.

Each of the first sub-pixel (PX1), the second sub-pixel (PX2), and the third sub-pixel (PX3) may be connected to at least one of the data lines (D1 to Dm), at least one of the scan lines (S1 to Sn), and a high-potential voltage line. The first sub-pixel (PX1) may include light emitting devices (LD), a plurality of transistors for supplying current to the light emitting devices (LD), and at least one capacitor (Cst), as shown in FIG. 3.

Although not shown in the drawing, each of the first sub-pixel (PX1), the second sub-pixel (PX2), and the third sub-pixel (PX3) may include only one light emitting device (LD) and at least one capacitor (Cst).

Each of the light emitting devices (LD) may be a semiconductor light-emitting diode including a first electrode, a plurality of conductive semiconductor layers, and a second electrode. Here, the first electrode may be an anode electrode, and the second electrode may be a cathode electrode, but is not limited thereto.

Referring to FIG. 3, the plurality of transistors may include a driving transistor (DT) that supplies current to the light emitting devices (LD), and a scan transistor (ST) that supplies a data voltage to a gate electrode of the driving transistor (DT). The driving transistor (DT) may include a gate electrode connected to a source electrode of the scan transistor (ST), a source electrode connected to a high-potential voltage line to which a high-potential voltage is applied, and a drain electrode connected to the first electrodes of the light emitting devices (LD). The scan transistor (ST) may include a gate electrode connected to a scan line (Sk, k is an integer satisfying 1≤k≤n), a source electrode connected to a gate electrode of a driving transistor (DT), and a drain electrode connected to a data line (Dj, j is an integer satisfying 1≤j≤m).

A capacitor (Cst) is formed between the gate electrode and the source electrode of the driving transistor (DT). The storage capacitor (Cst) may charge a difference value between the gate voltage and the source voltage of the driving transistor (DT).

The driving transistor (DT) and the scan transistor (ST) may be formed as thin film transistors. In addition, in FIG. 3, the driving transistor (DT) and the scan transistor (ST) are described as being formed as P-type MOSFETs (Metal Oxide Semiconductor Field Effect Transistors), but the embodiment is not limited thereto. The driving transistor (DT) and the scan transistor (ST) may also be formed as N-type MOSFETs. In this case, the positions of the source electrodes and the drain electrodes of each of the driving transistor (DT) and the scan transistor (ST) may be changed.

In addition, in FIG. 3, the first sub-pixel (PX1), the second sub-pixel (PX2), and the third sub-pixel (PX3) are exemplified as including 2T1C (2 Transistor - 1 capacitor) having one driving transistor (DT), one scan transistor (ST), and one capacitor (Cst), but the embodiment is not limited thereto. The first sub-pixel (PX1), the second sub-pixel (PX2), and the third sub-pixel (PX3) may each include a plurality of scan transistors (ST) and a plurality of capacitors (Cst).

Referring again to FIG. 2, the driving circuit (20) outputs signals and voltages for driving the display panel (10). For this purpose, the driving circuit (20) may include a data driving unit (21) and a timing control unit (22).

The data driving unit (21) receives digital video data (DATA) and a source control signal (DCS) from the timing control unit (22). The data driving unit (21) converts digital video data (DATA) into analog data voltages according to the source control signal (DCS) and supplies them to the data lines (D1 to Dm) of the display panel (10).

The timing control unit (22) receives digital video data (DATA) and timing signals from the host system. The timing signals may include a vertical sync signal, a horizontal sync signal, a data enable signal, and a dot clock. The host system may be an application processor of a smartphone or tablet PC, a monitor, a system on chip of a TV, etc.

The scan driving unit (30) receives a scan control signal (SCS) from the timing control unit (22). The scan driving unit (30) generates scan signals according to the scan control signal (SCS) and supplies them to the scan lines (S1 to Sn) of the display panel (10). The scan driving unit (30) may include a plurality of transistors and may be formed in a non-display area (NDA) of the display panel (10). Alternatively, the scan driving unit (30) may be formed as an integrated circuit, in which case it may be mounted on a gate flexible film attached to the other side of the display panel (10).

The power supply circuit (50) can generate a high-potential voltage (VDD) and a low-potential voltage (VSS) for driving the light emitting devices (LD) of the display panel (10) from the main power supply and supply them to the high-potential voltage line and the low-potential voltage line of the display panel (10). In addition, the power supply circuit (50) can generate and supply driving voltages for driving the driving circuit (20) and the scan driving unit (30) from the main power supply.

FIG. 4 is an enlarged view of the first panel area (A1) in the display device of FIG. 1.

According to FIG. 4, the display device (100) of the embodiment can be manufactured by mechanically and electrically connecting a plurality of panel areas such as the first panel area (A1) by tiling.

The first panel area (A1) can include a plurality of light emitting devices (150) disposed for each unit pixel (PX of FIG. 2).

For example, a unit pixel (PX) may include a first sub-pixel (PX1), a second sub-pixel (PX2), and a third sub-pixel (PX3). For example, a plurality of red light emitting devices (150R) may be disposed in a first sub-pixel (PX1), a plurality of green light emitting devices (150G) may be disposed in a second sub-pixel (PX2), and a plurality of blue light emitting devices (150B) may be disposed in a third sub-pixel (PX3). The unit pixel (PX) may further include a fourth sub-pixel in which no light emitting devices are disposed, but this is not limited thereto. Meanwhile, the light emitting device (150) may be a semiconductor light emitting device.

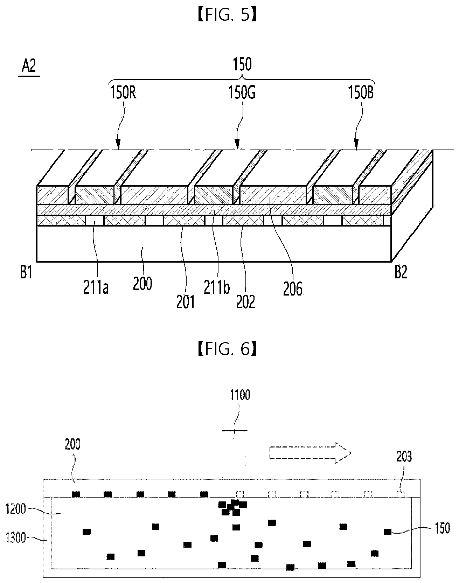

Next, FIG. 5 is a cross-sectional view along the line B1-B2 of the A2 region of FIG. 4.

Referring to FIG. 5, the display device (100) of the embodiment may include a substrate (200), an assembly wiring (201, 202), a first insulating layer (211a), a second insulating layer (211b), a third insulating layer (206), and a plurality of light emitting devices (150).

The assembly wiring may include a first assembly wiring (201) and a second assembly wiring (202) that are spaced apart from each other. The first assembly wiring (201) and the second assembly wiring (202) may be provided to generate a dielectric force for assembling the light emitting device (150). In addition, the first assembly wiring (201) and the second assembly wiring (202) may be electrically connected to an electrode of the light emitting device to function as an electrode of the display panel.

The assembly wiring (201, 202) may be formed of a light-transmitting electrode (ITO) or may include a metal material having excellent electrical conductivity. For example, the assembly wiring (201, 202) may be formed of at least one of titanium (Ti), chromium (Cr), nickel (Ni), aluminum (Al), platinum (Pt), gold (Au), tungsten (W), and molybdenum (Mo), or an alloy thereof.

A first insulating layer (211a) may be disposed between the first assembly wiring (201) and the second assembly wiring (202), and a second insulating layer (211b) may be disposed on the first assembly wiring (201) and the second assembly wiring (202). The first insulating layer (211a) and the second insulating layer (211b) may be an oxide film, a nitride film, or the like, but are not limited thereto.

The light emitting device (150) may include a red light emitting device (150), a green light emitting device (150G), and a blue light emitting device (150B) to form a unit pixel (sub-pixel), but is not limited thereto, and may include a red fluorescent element and a green fluorescent element to implement red and green, respectively.

The substrate (200) may be formed of glass or polyimide. In addition, the substrate (200) may include a flexible material such as PEN (Polyethylene Naphthalate) or PET (Polyethylene Terephthalate). In addition, the substrate (200) may be a light-transmitting material, but is not limited thereto.

The third insulating layer (206) may include an insulating and flexible material such as polyimide, PEN, PET, etc., and may be formed integrally with the substrate (200) to form a single substrate.

The third insulating layer (206) may be a conductive adhesive layer having adhesiveness and conductivity, and the conductive adhesive layer may be flexible to enable a flexible function of the display device. For example, the third insulating layer (206) may be a conductive adhesive layer such as an anisotropic conductive film (ACF) or an anisotropic conductive medium, a solution containing conductive particles, etc. The conductive adhesive layer may be a layer that is electrically conductive in a vertical direction relative to the thickness, but electrically insulating in a horizontal direction relative to the thickness.

The third insulating layer (206) may include an assembly hole (203) into which a light emitting device (150) is inserted (see FIG. 6). Therefore, during self-assembly, the light emitting device (150) may be easily inserted into the assembly hole (203) of the third insulating layer (206). The assembly hole (203) may be called an insertion hole, a fixing hole, an alignment hole, etc.

The gap between the assembly wiring (201, 202) is formed smaller than the width of the light emitting device (150) and the width of the assembly hole (203), so that the assembly position of the light emitting device (150) can be fixed more precisely using an electric field.

A third insulating layer (206) is formed on the assembly wiring (201, 202), so as to protect the assembly wiring (201, 202) from the fluid (1200) and prevent leakage of current flowing through the assembly wiring (201, 202). The third insulating layer (206) can be formed as a single layer or multiple layers of an inorganic insulator such as silica or alumina, or an organic insulator.

In addition, the third insulating layer (206) can include an insulating and flexible material such as polyimide, PEN, PET, etc., and can be formed integrally with the substrate (200) to form a single substrate.

The third insulating layer (206) may be an adhesive insulating layer or a conductive adhesive layer having conductivity. The third insulating layer (206) may be flexible to enable a flexible function of the display device.

The third insulating layer (206) may have a partition wall, and an assembly hole (203) may be formed by the partition wall. For example, when forming the substrate (200), a part of the third insulating layer (206) may be removed, so that each of the light emitting devices (150) may be assembled into the assembly hole (203) of the third insulating layer (206).

An assembly hole (203) in which the light emitting devices (150) are coupled is formed in the substrate (200), and a surface on which the assembly hole (203) is formed may be in contact with a fluid (1200). The assembly hole (203) may guide the exact assembly position of the light emitting devices (150).

Meanwhile, the assembly hole (203) may have a shape and size corresponding to the shape of the light emitting device (150) to be assembled at the corresponding position. Accordingly, it is possible to prevent another light emitting device from being assembled in the assembly hole (203) or a plurality of light emitting devices from being assembled.

FIG. 6 is a drawing showing an example in which a light emitting device according to an embodiment is assembled to a substrate by a self-assembly method, and the self-assembly method of the light emitting device is explained with reference to the drawings.

The substrate (200) may be a panel substrate of a display device. In the following description, the substrate (200) is described as a panel substrate of a display device, but the embodiment is not limited thereto.

Referring to FIG. 6, a plurality of light emitting devices (150) may be introduced into a chamber (1300) filled with the fluid (1200). The fluid (1200) may be, but is not limited to, ultrapure water. The chamber may be called a tank, a container, a vessel, etc.

After this, the substrate (200) may be placed on the chamber (1300). According to an embodiment, the substrate (200) may be introduced into the chamber (1300).

As shown in FIG. 5, a pair of assembly wirings (201, 202) corresponding to each of the light emitting devices (150) to be assembled may be placed on the substrate (200).

Referring to FIG. 6, after the substrate (200) is placed, an assembly device (1100) including a magnetic body may move along the substrate (200). For example, a magnet or an electromagnet may be used as the magnetic body. The assembly device (1100) may move in contact with the substrate (200) to maximize the area of the magnetic field applied to the fluid (1200). Depending on the embodiment, the assembly device (1100) may include a plurality of magnetic bodies or may include magnetic bodies of a size corresponding to the substrate (200). In this case, the movement distance of the assembly device (1100) may be limited within a predetermined range.

The light emitting device (150) in the chamber (1300) may move toward the assembly device (1100) by the magnetic field generated by the assembly device (1100).

While the light emitting device (150) moves toward the assembly device (1100), it may enter the assembly hole (203) by the dielectrophoretic force (DEP force) and come into contact with the substrate (200).

Specifically, the assembly wiring (201, 202) forms an electric field by an externally supplied power source, and a dielectric force can be formed between the assembly wiring (201, 202) by this electric field. The light emitting device (150) can be fixed to the assembly hole (203) on the substrate (200) by this dielectric force.

The light emitting device (150) in contact with the substrate (200) can be prevented from being detached by the movement of the assembly device (1100) by the electric field applied by the assembly wiring (201, 202) formed on the substrate (200). According to the embodiment, the time required for each of the light emitting devices (150) to be assembled on the substrate (200) can be drastically shortened by the self-assembly method using the above-described electromagnetic field, so that a large-area, high-pixel display can be implemented more quickly and economically.

At this time, a predetermined solder layer (not shown) may be formed between the light emitting device (150) assembled on the assembly hole (203) of the substrate (200) and the assembly electrode to improve the bonding strength of the light emitting device (150).

Next, a molding layer (not shown) may be formed on the assembly hole (203) of the substrate (200). The molding layer may be a light-transmitting resin or a resin containing a reflective material or a scattering material.

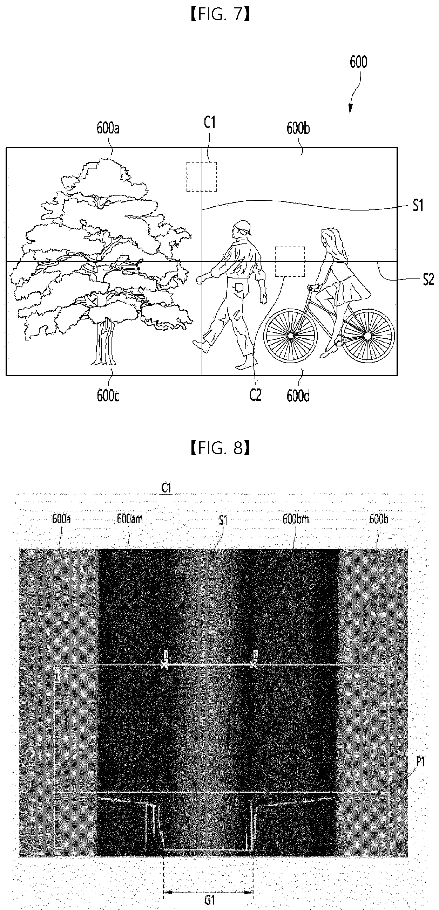

FIG. 7 illustrates a multi-screen display device (600) including a plurality of display panels according to an internal technology.

Referring to FIG. 7, the multi-screen display device (600) may be implemented in a form in which a plurality of display panels (600a to 600d) are tiled. For example, the multi-screen display device (600) may include, but is not limited to, first to fourth display panels (600a, 600b, 600c, 600d). Each of the plurality of display panels (600a to 600d) may be a display device manufactured by the self-assembly method described above, but is not limited thereto.

In the internal technology, the multi-screen display device (600) may be used as a large-area display device that provides one image through the plurality of display panels (600a to 600d), and each of the plurality of display panels (600a to 600d) may have a bezel area on the side minimized so that the gap area with the adjacent display device may be reduced.

According to the internal technology, as the gap area between the display devices is reduced, the dark area caused by the gap area can be minimized when outputting the image, and accordingly, the image with the minimized sense of disconnection can be displayed on the entire screen of the multi-screen display device (600).

Meanwhile, referring to FIG. 7, even though the gap, which is the physical gap between the multiple display panels of the internal technology, is reduced, there is a problem in that the gap or boundary line is recognized as a seam (S1) that is 'visually recognized' from an optical perspective.

For example, FIG. 8 is an example of a surface photograph of the first area (C1) of the display device (600) including the multiple display panels illustrated in FIG. 7.

Specifically, FIG. 8 is a surface photograph of the first boundary area (C1) of the first display module (600a) and the second display module (600b), and a predetermined gap (G1) exists between the side member (600am) of the adj acent first display panel and the side member (600bm) of the second display panel. In FIG. 8, 3D profile data (P1) for each component is expressed in the photograph.

In the display device of the internal technology, it is difficult to physically and mechanically reduce or eliminate the gap (G1) between the tiled display modules using existing technology, and even if the gap is reduced or eliminated, there is a problem that the boundary line is optically and visually recognized as a seam (S1).

Accordingly, it is necessary to prevent the gap between the display modules from being recognized as a seam optically, rather than just physically eliminating it.

In addition, although multiple display modules are tiled on a given chassis or cabinet in the internal technology, there is a problem of weak mechanical reliability because the side areas of adjacent display modules are not physically connected separately.

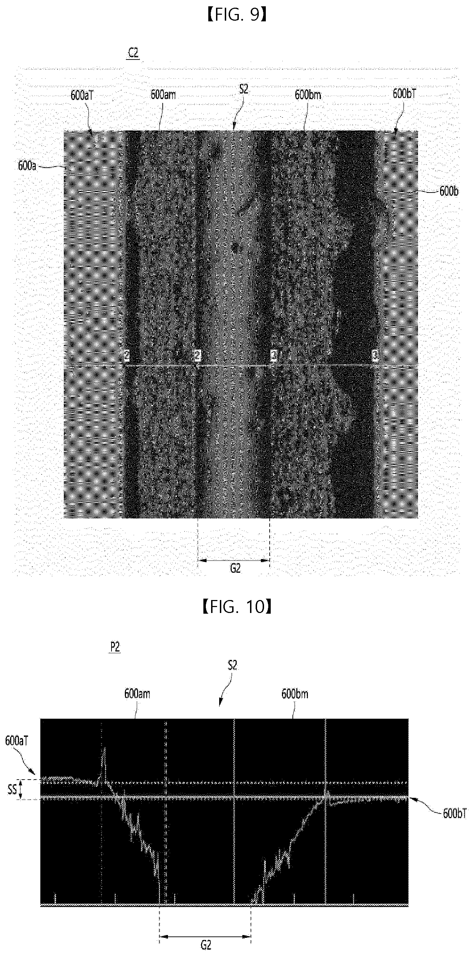

Next, FIG. 9 is an example of a surface photograph of a second area (C2) of a display device (600) including multiple display panels as shown in FIG. 7, and FIG. 10 is a 3D profile data (P2) for each component of FIG. 9.

Specifically, FIG. 9 is a surface photograph of a second boundary area (C2) of a first display module (600a) and a second display module (600b), and a predetermined second gap (G2) exists between the side member (600am) of the adjacent first display panel and the side member (600bm) of the second display panel.

FIG. 10 is a 3D profile data (P2) for each component of FIG. 9, and a height difference occurs between the upper surface (600aT) of the tiled first display panel and the upper surface (600bT) of the second display panel, resulting in a surface step (SS) between the display modules.

Accordingly, even if the gap between the display modules is filled according to the internal technology, if a surface step occurs between the display modules, there is a problem that it is recognized as a serious seam (S2) optically and visually, as shown in FIGs. 9 and 10.

Accordingly, one of the technical objects of the embodiment is to solve the problem of weak mechanical reliability between the side areas of adjacent display modules when multiple display modules are tiled.

In addition, one of the technical objects of the embodiment is not to physically eliminate the gap between the display modules, but to optically and visually not recognize it as a seam.

In addition, one of the technical objects of the embodiment is to solve the problem that even if the gap between the display modules is filled, if a surface step occurs between the display modules, it is optically recognized as a serious seam.

Hereinafter, a display device according to an embodiment for solving the above technical objects will be specifically described.

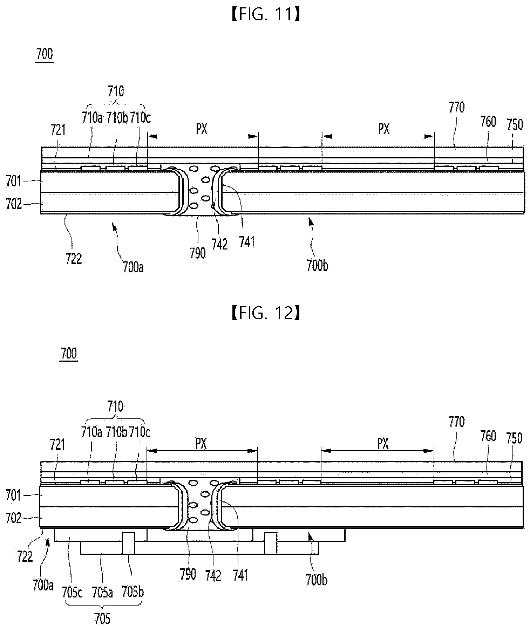

FIG. 11 is a side view of a boundary area between display modules of a display device (700) according to the first embodiment (hereinafter, 'the first embodiment' will be abbreviated as 'the embodiment'). For example, FIG. 11 is a side view of a boundary area between the first display module (700a) and the second display module (700b).

The display device (700) according to the embodiment may be a display device including a plurality of display modules.

For example, the display device (700) may be manufactured by tiling a plurality of display modules, and the display device may be manufactured in a tiling manner in which the semiconductor light emitting device assemblies (710) on adjacent display modules (700a, 700b) are disposed in close proximity to each other according to the pitch (PX) and then fixed.

Referring to FIG. 11, the display device (700) according to the embodiment may include at least one of a first module substrate (701), a second module substrate (702), a semiconductor light emitting device assembly (710), a side wiring (741), a wiring protection layer (742), a porous adhesive resin layer (790), a flattening film (750), a black matrix (720), an optical adhesive layer (760), and a cover film (770).

For example, the display device (700) according to the embodiment may include a first module substrate (701) and a second module substrate (702) disposed below the first module substrate (701).

The first module substrate (701) may be a TFT substrate on which TFTs (thin film transistors) and wires are formed, and the second module substrate (702) may be a PCB on which circuits such as a timing controller, a memory, a voltage source for driving a semiconductor light emitting device assembly (710), and various wires are formed.

In addition, the second module substrate (702) may be a PCB on which a driving unit for applying signals to the gate wires and data wires of the first module substrate (701) is formed, respectively. In this case, a plurality of wire electrodes (721, 722) may be formed on the first module substrate (701) and the second module substrate (702).

Also, according to the embodiment, TFT, wiring, and various circuits are formed on the second module substrate (702), and the first module substrate (701) may be implemented as a protective substrate for protecting the TFT and wiring.

In addition, the display device (700) according to the embodiment may include only one substrate, for example, the first module substrate (701). In this case, the features related to the lower surface of the second module substrate (702) described below may be applied equally to the lower surface of the first module substrate (701).

A plurality of semiconductor light emitting device assemblies (710) may be disposed in an array form on the first module substrate (701). For example, a plurality of semiconductor light emitting device assemblies (710) forming a plurality of rows and columns may be disposed on the first module substrate (701).

The semiconductor light emitting device assembly (710) may adopt the technical features of the semiconductor light emitting device (150) described above.

Each of the plurality of semiconductor light emitting device assemblies (710) is disposed spaced apart by a predetermined pitch (PX) and functions as one pixel, and at least one semiconductor light emitting device may be provided in the semiconductor light emitting device assembly (710).

For example, when the pixel includes R (red), G (green), and B (blue) sub-pixels, the semiconductor light emitting device assembly (710) may include, but is not limited to, a first semiconductor light emitting device (710a) that emits red light, a second semiconductor light emitting device (710b) that emits green light, and a third semiconductor light emitting device (710c) that emits blue light.

For example, the first to third semiconductor light emitting devices (710a, 710b, 710c) are all elements that emit one color, for example, blue light, and by arranging a fluorescent substance or QD thereon, various colors can be implemented through color conversion.

The embodiment may include a plurality of semiconductor light emitting device assemblies (710) and a wiring electrode (721) electrically connected on the first module substrate (701).

In addition, a plurality of wiring electrodes (not shown) formed in a vertical direction with respect to the wiring electrode (721) may be further formed on the first module substrate (701). For example, when the first module substrate (701) is a TFT substrate, the wiring electrode (721) may be implemented as a data wire or a gate wire, and the wiring electrode formed vertically with the wiring electrode (721) may be implemented as a different wire from the wiring electrode (721).

According to the embodiment, the wiring electrode (721) may correspond to a common electrode connected to the p electrode or n electrode of each of the plurality of semiconductor light emitting devices (710).

Meanwhile, the wiring electrode (721) formed on the first module substrate (701) is electrically connected to a voltage source or circuit of the second module substrate (702), and can receive signals related to driving a plurality of semiconductor light emitting device assemblies (710) or receive power.

The display device (700) according to the embodiment may further include a plurality of electrode pads (not shown) formed on the edge area of the upper surface of the first module substrate (701), and a side electrode (741) formed on the side of the display module. The plurality of electrode pads and the side electrode (741) may be formed of a conductive metal (Cu, Ag, etc.).

The side electrode (741) may be formed on the side of the first module substrate (701) and the second module substrate (702), respectively. One end of the side electrode (741) may be formed to be in contact with the side of the electrode pad on the first module substrate (701), and the other end may be connected to the second wiring electrode (722) formed on the lower part of the second module substrate (702).

In addition, in the display device (700) according to the embodiment, after the formation of the semiconductor light emitting device assembly (710), the second module substrate (702) may be bonded (adhered, etc.) to the lower part of the first module substrate (701), and a planarization layer (750) may be formed on the first module substrate (701).

The planarization layer (750) may be formed to a predetermined thickness to cover the upper surface of the first module substrate (701) and the semiconductor light emitting device assembly (710). The planarization layer (750) may provide a flat surface on the upper part of the display device (700) and may fix the position of the semiconductor light emitting device assembly (710).

The above-mentioned flattening layer (750) may correspond to an encapsulation layer that protects the semiconductor light emitting device assembly (710).

The above-mentioned flattening layer (750) may be formed by a process such as molding or hot melt. For example, the flattening layer (750) may be implemented with a light-transmitting or fluorescent material such as an acrylic resin, a polyimide resin, an epoxy resin, a polyurethane resin, etc.

Next, the embodiment may include an optical adhesive layer (760) on the above-mentioned flattening layer (750). The optical adhesive layer (760) may be a transparent adhesive material such as an OCA (Optical Clear Adhesive) or an OCR (Optically Clear Resin), but is not limited thereto.

Next, the embodiment may include a film layer (770) on the above-mentioned optical adhesive layer (760). The film layer (770) may include various optical films such as polarizing films, AG films, and AR films to prevent quality degradation (e.g., black contrast degradation) due to external light incident on the electrodes present on the upper surface of the first module substrate (701) being irradiated to the outside together with light emitted from semiconductor light emitting devices.

Meanwhile, according to the internal technology, there is a problem in which the gap between the display modules is recognized as a seam due to the gap between the display modules, and in particular, the seam is more visible when the display device is switched to a black state.

In addition, according to the internal technology, there is a problem in which an adhesive layer using OCA or a front cover is difficult to attach because there is an empty space between the display modules and the modules.

In addition, according to the internal technology, there is a problem in which the cover is bent due to the step (empty space) in the seam when the front cover is attached, and the seam is more prominent.

Accordingly, the display device (700) according to the embodiment can solve the above technical problem by arranging a porous adhesive resin layer (790) on the first display module (700a) and the second display module (700b). The porous adhesive resin layer (790) may be formed on the side of each of the first display module (700a) and the second display module (700b) and then converted into a single body by a pressing process of the display modules.

The porous adhesive resin layer (790) may use at least one porous material among urethane foam or PP (Polypropylene), TPU (Thermo Plastic Polyurethane), TPO (Thermo Plastic Olefin), and compressed styrofoam.

In addition, the porous adhesive resin layer (790) may further include urethane resin, terpene resin, etc. as an adhesive material. In addition, the embodiment may further include a thermoplastic resin such as polystyrene, polyethylene, polypropylene, methacrylic, or acrylic, and may be manufactured by mixing a black pigment into thermoplastic resin.

The porous adhesive resin layer (790) may be a soft porous material that has a technical effect of trapping reflections due to external light into a porous space by applying a light-absorbing layer to reduce light recognition.

The porous adhesive resin layer (790) may be formed to have a thickness of 200 µm or less, preferably 150 µm or less, but is not limited thereto.

The density of the porous adhesive resin layer (790) may be 0.15 to 0.4 g/cm3, but is not limited thereto.

In addition, the embodiment may further include a light-absorbing soft resin of the urethane, epoxy, or silicone series.

Hereinafter, a method for manufacturing a display device (700) according to an embodiment will be described with reference to FIG. 12.

The embodiment may form a porous adhesive resin layer (790) on the side of each of the first display module (700a) and the second display module (700b).

Meanwhile, a predetermined resin blocking film (not shown) may be placed on the semiconductor light emitting device assembly (710) to prevent the porous adhesive resin layer (790) from overflowing onto the light emitting device assembly (710).

Thereafter, the porous adhesive resin layer (790) may be formed by applying it to the side of the first display module (700a) and the second display module (700b) using an inkjet or the like.

The porous adhesive resin layer (790) may be a foam series in which an air layer is formed as a porous material, and may have a black color for absorbing light. **In** addition, the porous adhesive resin layer (790) may use a foamed resin or an air-dispersed resin.

The porous adhesive resin layer (790) may include a soft resin to provide elasticity, thereby preventing mechanical damage when fixing the first display module (700a) and the second display module (700b) by compressing them to a predetermined pitch (PX) and firmly maintaining the pitch.

After that, the resin blocking film positioned on the first display module (700a) and the second display module (700b) may be removed, and then the module frame (705) attachment process and the module alignment process may be performed.

The module frame (705) may include a support frame (705c), a connection frame (705a), and a fixed frame (705b), and based on the module frame (705), a plurality of modules may be fastened to each other to maintain the overall flatness and spacing.

After that, an optical adhesive layer (760) and a film layer (770) can be attached.

According to the embodiment, since the gap between the modules is filled, there is a technical effect of preventing a boundary bending phenomenon when the optical adhesive layer (760) and the film layer (770) are attached on the aligned modules.

The technical effect of the display device (700) according to the embodiment will be described in detail with reference to FIGS. 13 to 15 below.

FIG. 13 shows a multi-screen display device (700) including a plurality of display panels according to the embodiment.

Referring to FIG. 13, the display device (700) according to the embodiment may be implemented in a form in which multiple display panels (700a to 700d) are tiled. For example, the multi-screen display device (700) may include first to fourth display panels (700a, 700b, 700c, 700d), but is not limited thereto. Each of the multiple display panels (700a to 700d) may be a display device manufactured by the self-assembly method described above, but is not limited thereto.

Referring to FIG. 13, unlike the display device (600) of FIG. 7 of the internal technology, there is a technical effect in which the boundary area between the multiple display panels (700a to 700d) may not be recognized as a depth.

For example, FIG. 14 is an example of a surface photograph of a third area (C3) of a display device (700) illustrated in FIG. 13, and 3D profile data (P3) for each component is expressed in the photograph.

Specifically, FIG. 14 is a surface photograph of a third boundary area (C1) of a first display module (700a) and a second display module (700b), and since a porous adhesive resin layer (790) is disposed between the adjacent first display modules (700a) and second display modules (700b), the boundary line has a special technical effect that is not optically and visually recognized as a seam.

For example, the porous adhesive resin layer (790) of the embodiment has a special technical effect that functions as a seam absorbing layer as a soft porous material and traps reflections due to external light into the porous space to reduce seam recognition.

Next, according to the embodiment, the porous adhesive resin layer (790) is used as a medium to directly bond between modules, so that there is no gap between the modules, and thus a perfect seamless implementation is possible.

In addition, according to the embodiment, the porous adhesive resin layer (790) is used as a medium to directly bond between modules, so that there is no need to separately fix the modules, and thus there is a technical effect of excellent structural reliability.

Next, FIG. 15 is an example of a surface photograph of the fourth area (C4) of the display device (700) illustrated in FIG. 15.

Specifically, FIG. 15 is a surface photograph of the fourth boundary area (C4) of the first display module (700a) and the second display module (700b), and even if there is a height difference between the upper surface (700aT) of the tiled first display module and the upper surface (700bT) of the second display module, there is a special technical effect in that the porous adhesive resin layer (790) is disposed to function as a deep light-absorbing layer, thereby scattering and trapping the reflection of external light into the porous space so that it is not recognized as a seam optically and visually.

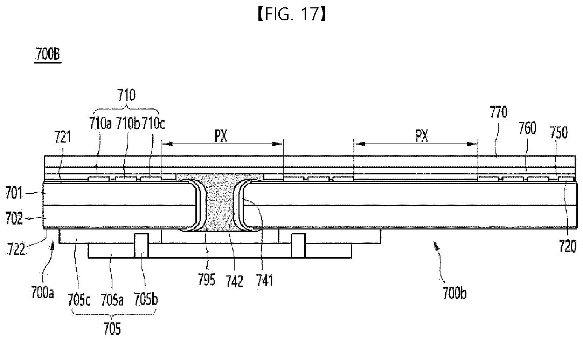

Next, FIG. 16 is a side view of the boundary area between the display modules of the display device (700B) according to the second embodiment, and FIG. 17 is an example diagram of a manufacturing method of the display device (700B) according to the second embodiment.

The second embodiment can adopt the technical features of the first embodiment.

For example, a display device (700B) according to the second embodiment may include a first display module (700a) and a second display module (700b). The first display module (700a) and the second display module (700b) may each include at least one of a first module substrate (701), a second module substrate (702), a semiconductor light emitting device assembly (710), a side wiring (741), a wiring protection layer (742), a flattening film (750), an optical adhesive layer (760), and a cover film (770).

The main features of the second embodiment will be described below.

A display device (700B) according to the second embodiment may solve a technical problem by arranging a viscoelastic resin layer (795) on the first display module (700a) and the second display module (700b). The viscoelastic resin layer (795) may be formed on the sides of each of the first display module (700a) and the second display module (700b) and then converted into a single body by a pressing process of the display modules.

The viscoelastic resin layer (795) may include a material such as epoxy or rubber.

In addition, the viscoelastic resin layer (795) may further include a urethane resin, a terpene resin, etc. as an adhesive material. In addition, the embodiment may further include a thermoplastic resin such as polystyrene, polyethylene, polypropylene, methacrylic, or acrylic, and may be manufactured by mixing a black pigment into thermoplastic resin.

The viscoelastic resin layer (795) has a technical effect of reducing the recognition of the mind by trapping the reflection due to external light by applying a light-absorbing layer.

Hereinafter, a method for manufacturing a display device (700B) according to the second embodiment will be described with reference to FIG. 17.

The embodiment may form a viscoelastic resin layer (795) on the side of each of the first display module (700a) and the second display module (700b), and a predetermined resin blocking film (not shown) may be placed on the semiconductor light emitting device assembly (710) to prevent the viscoelastic resin layer (795) from overflowing onto the light emitting device assembly (710).

The viscoelastic resin layer (795) may be formed by applying it to the side of the first display module (700a) and the second display module (700b) using an inkjet, etc.

The viscoelastic resin layer (795) has viscoelasticity, so that when it is compressed and fixed between the first display module (700a) and the second display module (700b) at a predetermined pitch (PX), it can prevent mechanical damage and firmly maintain the pitch.

In an embodiment, the viscoelastic resin layer (795) has an effect of reducing reflection due to external light and thus reducing seam recognition, and the material of the viscoelastic resin layer (795) can have fluidity within a certain temperature range and time before complete curing.

Unlike the display device (600) of FIG. 7 of the internal technology, the display device (700B) according to the second embodiment has a technical effect in that the boundary area between the plurality of display panels (700a to 700d) is not recognized as a seam.

For example, since a viscoelastic resin layer (795) is disposed between adjacent first display modules (700a) and second display modules (700b), there is a special technical effect in which the boundary line is not optically and visually recognized as a deep line.

In addition, according to the second embodiment, since the modules are directly bonded using the viscoelastic resin layer (795) as a medium, there is a technical effect in which a perfect seamless implementation is possible since there is no gap between the modules themselves.

In addition, according to the second embodiment, since the modules are directly bonded using the viscoelastic resin layer (795) as a medium, there is no need to separately fix the modules, and there is a technical effect in which the modules are structurally highly reliable.

Also, according to the second embodiment, even if there is a height difference between the upper surface (700aT) of the tiled first display module and the upper surface (700bT) of the second display module, the viscoelastic resin layer (795) is disposed so that it functions as a seam absorbing layer to diffuse and trap reflections due to external light, thereby preventing it from being recognized as a seam optically and visually.

The above description is merely an example of the technical idea of the present invention, and those skilled in the art will be able to make various modifications and variations without departing from the essential characteristics of the present invention.

Therefore, the embodiments disclosed in the present invention are not intended to limit the technical idea of the present invention, but to explain it, and the scope of the technical idea of the present invention is not limited by these embodiments.

The scope of protection of the present invention should be interpreted by the claims below, and all technical ideas within the scope equivalent thereto should be interpreted as being included in the scope of the rights of the present invention.

### [Industrial Applicability]

The embodiment can be adopted in the field of displays that display images or information.

The embodiment can be adopted in the field of displays that display images or information using semiconductor light emitting devices.

The embodiment can be adopted in the field of displays that display images or information using micro-level or nano-level semiconductor light emitting devices.

## Claims

1. A display device of a semiconductor light emitting device, comprising:
a first display module substrate and a second display module substrate that are disposed adjacently;
a plurality of semiconductor light emitting device assemblies disposed on the first, second display module substrates, respectively;
first and second side wirings disposed on the sides of the first, second display module substrates, respectively, and electrically connected to the semiconductor light emitting device assemblies; and
a porous adhesive resin layer disposed between the first display module substrate and the second display module substrate;

2. The display device of the semiconductor light emitting device according to the claim 1, wherein the porous adhesive resin layer comprises a first porous adhesive resin layer disposed on the first side wiring of the first display module substrate and a second porous adhesive resin layer disposed on the second side wiring of the second display module substrate, and
wherein he first and second porous adhesive resin layers are combined to form a single body.

3. The display device of the semiconductor light emitting device according to the claim 1, wherein a surface step exists between an upper surface of the first display module substrate and an upper surface of the second display module substrate.

4. The display device of the semiconductor light emitting device according to the claim 1, further comprises a planarizing film disposed on the first and second module substrates.

5. The display device of the semiconductor light emitting device according to the claim 1, further comprising an optical adhesive layer and a cover film disposed on the first and second module substrates.

6. A display device of a semiconductor light emitting device, comprising:
a first display module substrate and a second display module substrate disposed adjacently;
a plurality of semiconductor light emitting device assemblies disposed on the first, second display module substrates, respectively;
first and second side wirings disposed on sides of the first, second display module substrates, respectively and electrically connected to the semiconductor light emitting device assemblies; and
a viscoelastic resin layer disposed between the first display module substrate and the second display module substrate;

7. The display device of the semiconductor light emitting device according to the claim 6, wherein the viscoelastic resin layer comprises a first viscoelastic resin layer disposed on the first side wiring of the first display module substrate and a second viscoelastic resin layer disposed on the second side wiring of the second display module substrate, and
wherein the first and second viscoelastic resin layers are combined to form a single body.

8. The display device of the semiconductor light emitting device according to the claim 6, wherein a surface step exists between an upper surface of the first display module substrate and an upper surface of the second display module substrate.

9. The display device of the semiconductor light emitting device according to the claim 6, further comprising a planarizing film disposed on the first and second module substrates.

10. The display device of the semiconductor light emitting device according to the claim 6, further comprising an optical adhesive layer and a cover film disposed on the first and second module substrates.
